# EUROPEAN PATENT SPECIFICATION

(11) **EP 3 493 258 B1**
(45) Date of publication and mention of the grant of the patent: **24.02.2021**
(21) Application number: 18208104.2
(22) Date of filing: 23.11.2018
(51) Int. Cl.: H01L 25/075, H01L 33/56, G09F 9/33

(54) **LED DISPLAY MODULE AND MANUFACTURING METHOD THEREOF**
LED-ANZEIGEMODUL UND HERSTELLUNGSVERFAHREN DAFÜR
MODULE D'AFFICHAGE À DEL ET SON PROCÉDÉ DE FABRICATION

(30) Priority: 29.11.2017 CN 201711230777
(43) Date of publication of application: 05.06.2019
(73) Proprietor: Leyard Optoelectronic Co., Ltd., North of Summer Palace, Haidian District, Beijing 100091 (CN)
(72) Inventor: ZHANG, Longhu, Haidian District, Beijing 100091 (CN); WANG, Hongwei, Haidian District, Beijing 100091 (CN); WANG, Yong, Haidian District, Beijing 100091 (CN)
(74) Representative: Mozzi, Matteo

(56) References cited:
- EP-A1- 2 963 685
- EP-A1- 2 980 870
- WO-A1-2012/145237
- WO-A1-2015/024364
- CN-A- 107 038 965
- CN-B- 103 208 239
- US-A1- 2012 112 220
- US-A1- 2013 043 493
- US-A1- 2016 276 546

## Description

### Technical Field

The present invention relates to the technical field of LED display modules, and particularly to a small pitch LED display module and a manufacturing method thereof.

### Background

An LED display screen is formed by an LED dot matrix and displays a text and a picture by turning on/off lamp beads, the content may be replaced anytime, and each component is a display device of a modular structure. An LED display module usually comprises a mounting substrate and an LED lamp panel, and the LED lamp panel comprises a circuit board and multiple LEDs which are positioned on the circuit board and arranged in an array. According to distances between LEDs, LED display modules are divided into a large-spacing type and a small pitch type.

For a small pitch LED display module, it has no waterproof property, and in addition, LEDs are weak in welding force and close to an edge of a lamp panel. Various problems such as LED collision, difficulties in surface cleaning and LED damage in case of excessive humidity of the LEDs are easily brought to the LED display module, so it is required to be packaged. At present, the following packaging manners are mainly adopted for small pitch LED display modules: 1) a Chip On Board (COB) sealing process: the process has the problems of serious deformation, difficulties in process control and lower finished product ratio; 2) packaging with integrated glass or plastic plate: by such a method, dimensions of LED display modules are easily limited, and difficulties in mounting and transportation are greater; 3) a coating process: cost is higher; and 4) a glue injection process: this method may reduce optical performance of the LED display modules and bring more serious moire problems.

EP 2963685 A1, US 2016/0276546 A1, US 2012/0112220 A1, and WO 2012/145237 all disclose LED display modules with an LED lamp panel comprising a circuit board, multiple LEDs arranged on the circuit board, and a protective colloid comprising a first part arranged between the LEDs and a second part arranged on the first part and the LEDs. In particular WO 2012/0112220 A1, also discloses a manufacturing method, wherein the protective colloid is laminated onto and between the LEDs by a press and subsequently cured.

On the basis of the above reasons, it is necessary to provide a small pitch LED display module structure which is simple, reliable, lower in cost and higher in optical performance, and a manufacturing method thereof.

### Summary

The present invention is mainly intended to provide a small pitch LED display module and a manufacturing method thereof, so as to solve the problem of incapability of an LED protection process for a small pitch LED display module in combining high reliability, low cost and high optical performance in a conventional art.

In order to achieve the purpose, according to an aspect of the present invention, a small pitch LED display module according to claim 1 is provided.

Furthermore, the protective colloid may be a hardened colloid formed by curing normal temperature curable glue; and preferably, the normal temperature curable glue may be selected from a resin adhesive, the resin adhesive may preferably be an epoxy resin adhesive and/or modified silica gel, and a coloring agent and/or a dispersant may preferably be added into the resin adhesive.

Furthermore, the second colloid part may have a haze of 4-8% and glossiness of 75-85.

According to the other aspect of the present invention, a manufacturing method for a small pitch LED display module according to claim 4 is furthermore provided.

Furthermore, a glue filling process may be implemented in a vacuum environment.

Furthermore, the glue filling process may comprise the following step: a glue gun is reciprocally moved above the side, far away from the mounting substrate, of the LED lamp panel, and the glue is discharged at the same time of reciprocal movement.

Furthermore, the glue may be normal temperature curable glue, the normal temperature curable glue may preferably be selected from a resin adhesive, the resin adhesive may preferably be an epoxy resin adhesive and/or modified silica gel, and a coloring agent and/or a dispersant may preferably be added into the resin adhesive.

Furthermore, the frosted plate may be a frosted glass or an AG frosted membrane.

Furthermore, a thickness of the frosted plate may be 0.1∼1.0mm.

Furthermore, pressure in a lamination process may be 0.005-0.04MPa, and a curing time in a curing process may be 0.5∼6h.

According to the small pitch LED display module provided by the present invention, the protective colloid is arranged in the gaps between and above the LEDs, and the protective colloid comprises the first colloid part and the second colloid part. Thus, the first colloid part positioned in the gaps and the second colloid part positioned above the LEDs may realize a good protection function on each LED, and the problems of collision of the LEDs and LED damage caused by excessive humidity may be effectively prevented. Meanwhile, the second colloid part is also positioned above each LED and the first colloid part, so that a surface of the LED lamp panel is easier to clean.

In addition, the thickness of the second colloid part is smaller than 1.0mm, and the surface of the side, far away from the circuit board, of the second colloid part is a rough surface. The smaller thickness and the rough surface are favorable for improving an antireflection effect of the protective colloid, thereby reducing moire problems caused by the protective colloid. Thus, the small pitch LED display module of the present invention has higher anti-glare performance at the same time of protecting the LEDs better and keeping higher optical performance. Moreover, a processing manner for the protective colloid is simple, convenient and reliable for processing and suitable for industrial application.

### Brief Description of the Drawings

The specification drawings forming a part of the application are adopted to provide a further understanding to the present invention. Schematic embodiments of the present invention and descriptions thereof are adopted to explain the present invention and not intended to form improper limits to the present invention. In the drawings:
Fig. 1 is a structure diagram of a small pitch LED display module according to an embodiment of the present invention;
Fig. 2 is a section view of a small pitch LED display module structure shown in Fig. 1;
Fig. 3 is a schematic diagram of a glue filling process in a manufacturing method for a small pitch LED display module according to an embodiment of the present invention;
Fig. 4 is a schematic diagram of a frosted plate lamination process in a manufacturing method for a small pitch LED display module according to an embodiment of the present invention;
Fig. 5 is a schematic diagram of a curing process in a manufacturing method for a small pitch LED display module according to an embodiment of the present invention;
Fig. 6 is a schematic diagram of a process of removing a frosted plate in a prefabricated module in a manufacturing method for a small pitch LED display module according to an embodiment of the present invention;
Fig. 7 is a moire display image of a small pitch LED display module manufactured according to embodiment 1 of the present invention; and
FIG. 8 is a moire display image of a small pitch LED display module manufactured according to contrast example 1.

### Detailed Description of the Embodiments

It is important to note that embodiments in the application and characteristics in the embodiments may be combined without conflicts. The present invention will be described below with reference to the drawings and in combination with the embodiments.

The application will further be described below in combination with specific embodiments in detail, and these embodiments should not be understood to limit the scope required by the application to be protected.

As mentioned in the Background, an LED protection process for a small pitch LED display module in the conventional art may not combine high reliability, low cost and high optical performance.

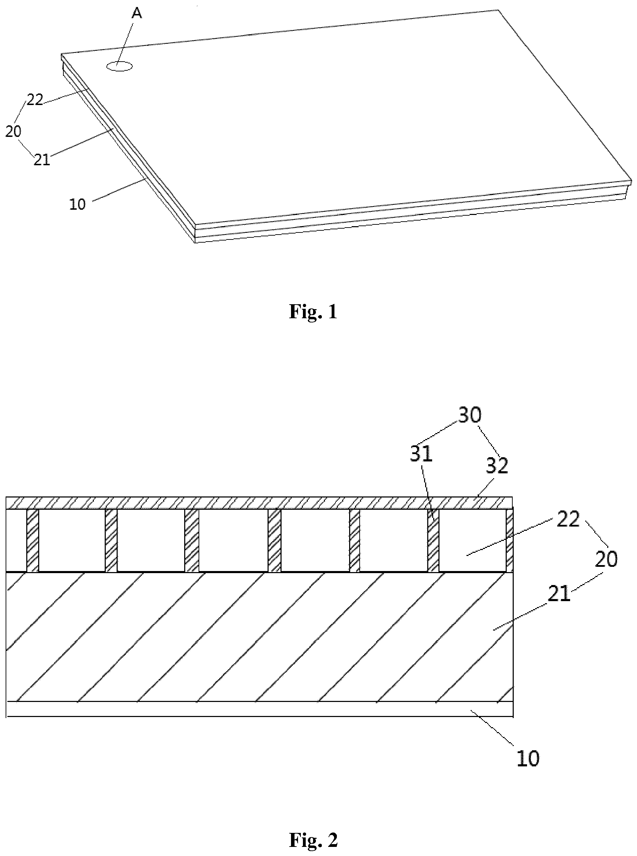

In order to solve the problem, the present invention provides a small pitch LED display module. As shown in Fig. 1 and 2, the small pitch LED display module comprises a mounting substrate 10, an LED lamp panel 20 and a protective colloid 30. The LED lamp panel 20 comprises a circuit board 21 and multiple LEDs 22 arranged on the circuit board 21 at intervals, the circuit board 21 is arranged on a surface of one side of the mounting substrate 10, and the LEDs 22 are arranged on a surface of the side, far away from the mounting substrate 10, of the circuit board. The protective colloid 30 comprises a first colloid part 31 and a second colloid part 32. The first colloid part 31 is arranged in gaps between the LEDs 22, and the second colloid part 32 is positioned on upper surfaces of the first colloid part 31 and the LEDs 22. A thickness of the second colloid part 32 is smaller than 1.0mm, and a surface of the side, far away from the circuit board 21, of the second colloid part is a rough surface.

According to the small pitch LED display module provided by the present disclosure, the protective colloid 30 is arranged in the gaps between and above the LEDs, and the protective colloid 30 comprises the first colloid part 31 and the second colloid part 32. Thus, the first colloid part 31 positioned in the gaps and the second colloid part 32 positioned above the LEDs may realize a good protection function on each LED, and the problems of collision of the LEDs 22 and LED damage caused by excessive humidity may be effectively prevented. Meanwhile, the second colloid part 32 is also positioned above each LED 22 and the first colloid part, so that a surface of the LED lamp panel 20 is easier to clean. In addition, the thickness of the second colloid part 32 is smaller than 1.0mm, and the surface of the side, far away from the circuit board, of the second colloid part is a rough surface. The smaller thickness and the rough surface are favorable for improving an antireflection effect of the protective colloid, thereby reducing moire problems caused by the protective colloid. Thus, the small pitch LED display module of the present invention with higher anti-glare performance at the same time of protecting the LEDs 22 better and keeping higher optical performance. Moreover, a processing manner for the protective colloid is simple, convenient and reliable for processing and suitable for industrial application.

It is important to note that the first colloid part 31 and the second colloid part 32 directly contact with each other and there is no boundary therebetween. In Fig. 2, for convenient structure description, the part, positioned in the gaps, of the protective colloid 30 is represented as the first colloid part 31. A surface of the side, far away from the circuit board 21, of the first colloid part 31 is flush with surfaces of the sides, far away from the circuit board 21, of the LEDs 22. The part, higher than the gaps and the LEDs 22, of the protective colloid 30 is represented as the second colloid part 32.

It is also important to note herein that the thickness of the second colloid part 32 is very small and light emitting angles of modules are higher in consistent, so that an LED display screen is endowed with higher anti-glare performance and higher optical performance. In a practical using process, the thickness of the second colloid part 32 is as small as possible. Considering factors of convenience for machining and the like, the thickness of the second colloid part 32 is preferably smaller than 1.0mm and larger than 0.1mm.

In a preferred implementation mode, the protective colloid 30 is a hardened colloid formed by curing normal temperature curable glue. Selecting the normal temperature curable glue may further simplify a process and is favorable for preventing the problems of heating deformation and the like. Preferably, the normal temperature curable glue is selected from a resin adhesive, the resin adhesive is preferably an epoxy resin adhesive and/or modified silica gel, and a coloring agent and/or a dispersant are/is preferably added into the resin adhesive. Curing time and viscosities of the abovementioned glue are more suitable. In a specific machining process, the gaps between the LEDs 22 may be rapidly filled by virtue of high flowability to form the first colloid part 31, and the redundant glue may also be rapidly cleaned to form the second colloid part 32 with a smaller thickness. The coloring agent and the dispersant are added into the resin adhesive, so that the lamp panel may be covered by the glue more completely.

In accordance with the present invention, roughness of the surface of the side, far away from the circuit board 21, of the second colloid part 32 is 0.2∼2 µ m. The second colloid part 32 with this roughness has a better antireflection effect, and may further improve the optical performance of the LED display module. More preferably, the second colloid part 32 has a haze of 4-8% and glossiness of 75∼85.

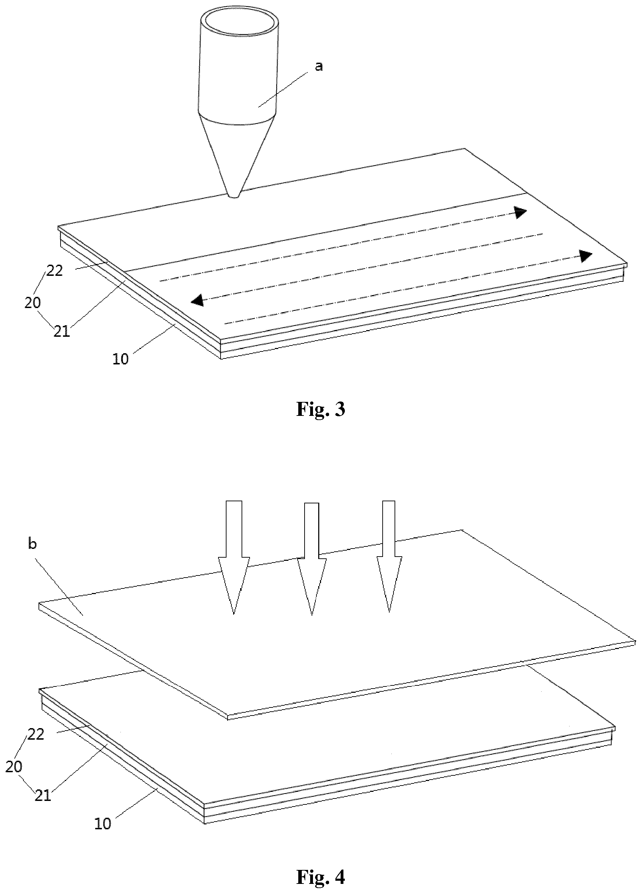

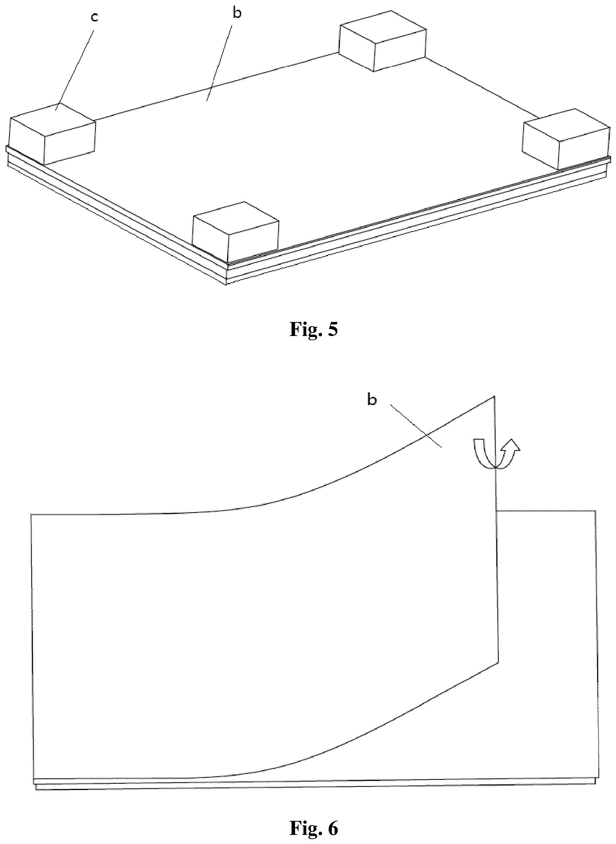

According to the other aspect of the present invention, a manufacturing method for a small pitch LED display module is further provided, which is simple and reliable in process. As shown in Fig. 3, in a glue filling process, the glue may flow into the gaps between the LEDs 22 on the LED lamp panel 20. In this process, besides the glue flowing between the LEDs 22, some glue may remain above the LEDs 22, and laminating the side bearing the glue by virtue of the frosted plate b may further fill the gaps between the LEDs 22 with the glue and extrude the redundant glue (as shown in Fig. 4). After the redundant glue is extruded, as shown in Fig. 5, curing is performed in a pressure plate lamination state to form the protective colloid 30 comprising the first colloid part 31 and the second colloid part 32 to further form the prefabricated module. Second, as shown in Fig. 6, after the frosted plate b in the prefabricated module is removed, the small pitch LED display module may be obtained, and in the display module, a surface of the side, far away from the circuit board 21, of the first colloid part 31 is flush with surfaces of the sides, far away from the circuit board 21, of the LEDs 22, the second colloid part 32 is positioned on upper surfaces of the first colloid part 31 and the LEDs 22, a thickness of the second colloid part 32 is smaller than 1.0mm, and a surface of the side, far away from the circuit board 21, of the second colloid part 32 is a rough surface.

It is important to note that "extruding the redundant glue" refers to that the glue between the pressure plate and the LED lamp panel is extruded after the glue enters the gaps between the LEDs and the redundant glue is cured to form the protective colloid. Those skilled in the art should know about a meaning of "redundant" mentioned here.

The first colloid part 31 positioned in the gaps and the second colloid part 32 positioned above the LEDs may realize a good protection function on each LED, and the problems of collision of the LEDs 22 and LED damage caused by excessive humidity may be effectively prevented. Meanwhile, the second colloid part 32 is also positioned above each LED 22 and the first colloid part, so that a surface of the LED lamp panel 20 is easier to clean. In addition, the thickness of the second colloid part 32 is smaller than 1.0mm, the surface of the side, far away from the circuit board, of the second colloid part is a rough surface. The smaller thickness and the rough surface are favorable for improving an antireflection effect of the protective colloid, thereby reducing moire problems caused by the protective colloid, endowing the small pitch LED display module of the present disclosure with higher anti-glare performance at the same time of protecting the LEDs 22 better and keeping higher optical performance. Moreover, a processing manner for the protective colloid is simple, integrally forms the protective colloid 30 with a rough surface by virtue of "glue filling-frosted plate lamination-curing", and is convenient and reliable for processing and suitable for industrial application, and no complex equipment is required.

In a practical manufacturing process, after the protective colloid 30 is formed, shape cutting may be performed on the LED display module according to a dimensional requirement.

In a preferred implementation mode, the glue filling process is implemented in a vacuum environment. This is favorable for removing air in the gaps between the LEDs, reducing bubbles and filling the gaps with the glue more completely.

In a preferred implementation mode, as shown in Fig. 3, the glue filling process comprises the following step: a glue gun a is reciprocally moved above the side, far away from the mounting substrate 10, of the LED lamp panel 20, and the glue is discharged at the same time of reciprocal movement. By such glue filling, the glue may stably flow into the gaps, a few bubbles are generated in a glue discharging process and a glue flowing process, and improvement in integrity of the protective colloid 30 is facilitated, and a better protection function on each LED 22 may be realized.

In a preferred implementation mode, the glue is normal temperature curable glue. Selecting the normal temperature curable glue may further simplify the process and is favorable for preventing the problems of heating deformation and the like. The normal temperature curable glue is preferably selected from a resin adhesive, the resin adhesive is preferably an epoxy resin adhesive and/or modified silica gel, and preferably, a coloring agent and/or a dispersant are/is added into the resin adhesive. In a preferred implementation mode, the frosted plate b is frosted glass or an AG frosted membrane. Using the frosted plate with a surface roughness of 0.2-2.0 µm for lamination may endow an upper surface of the second colloid part 32 with the roughness of 0.2-2 µ m. The second colloid part 32 with such roughness has a better antireflection effect and may further improve optical performance of the LED display module.

In a preferred implementation mode, a thickness of the frosted plate b is 0.1∼1.0mm. It is easier to remove the frosted plate b with such a thickness from the LEDs 22 and the protective colloid 30, which is favorable for further reducing difficulties in machining.

In a preferred implementation mode, pressure in a lamination process is 0.005∼0.04MPa, and a curing time in a curing process is 0.5∼6h. In a specific operating process, the frosted plate b may be pressed by pressure blocks c for curing in the curing process, and after complete curing, the pressure blocks c are removed and the frosted plate b is removed. In addition, a frosted plate lamination manner is adopted in the present invention, and frosted plate lamination may be secondarily regulated before the glue is cured, so that air between the frosted plate, the glue and the LEDs 22 may be discharged more completely.

The beneficial effects of the present invention will further be described below according to the embodiments.

### Embodiment 1

A small pitch LED display module is manufactured in the embodiment, and a specific process is as follows.

An LED lamp panel is selected, with a model number of TVH2.5, and is arranged on a mounting substrate. Dot distance of its LEDs is 2.5mm, and a dimension of the LED lamp panel is 200X 150mm.

Glue filling is performed on the side, far away from the mounting substrate, of the LED lamp panel by adopting a normal temperature curable epoxy resin adhesive.

Second, the side bearing glue is laminated (pressure is 0.04MPa) by virtue of an AG frosted plate (surface roughness is 0.2 µ m) to enable the glue to enter gaps between the LEDs and extrude redundant glue, and then curing (6h) is performed to form a protective colloid to further form a prefabricated module. The protective colloid comprises a first colloid part and a second colloid part, and the first colloid part is arranged in the gaps between the LEDs; and the second colloid part is positioned on upper surfaces of the first colloid part and the LEDs, a thickness of the second colloid part is 0.1mm, a surface of the side, far away from the circuit board, of the second colloid part is a rough surface with roughness of 0.2 µ m, and the second colloid part has a haze of 4% and glossiness of 80.

The frosted plate in the prefabricated module is removed to form the small pitch LED display module.

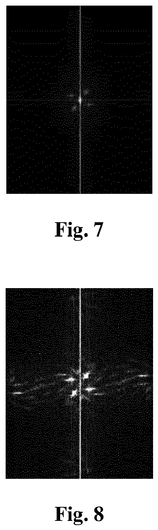

Performance of the small pitch LED display module is characterized, a reflectivity detector is used to detect reflectivity of a surface of the module, and visible light reflectivity is 0.2%. A moire display image obtained by converting an original image of the small pitch LED display module into a grayscale image and performing Fourier transform is shown in Fig. 7.

### Embodiment 2

A manufacturing process for a small pitch LED display module in the embodiment is the same as embodiment 1, expect for some differences as follows.

The surface roughness of the AG frosted plate is 0.2 µ m, the lamination pressure is 0.005MPa, the thickness of the second colloid part in the formed protective colloid is 0.8mm, the surface of the side, far away from the circuit board, of the second colloid part is a rough surface with roughness of 2 µ m, and the second colloid part has a haze of 10% and glossiness of 85. Performance of the small pitch LED display module is characterized, and visible light reflectivity is 3%.

### Embodiment 3

A manufacturing process for a small pitch LED display module in the embodiment is the same as embodiment 1, expect for some differences as follows.

The surface roughness of the AG frosted plate is 0.2 µ m, the lamination pressure is 0.02MPa, the thickness of the second colloid part in the formed protective colloid is 0.5mm, the surface of the side, far away from the circuit board, of the second colloid part is a rough surface with roughness of 1 µ m, and the second colloid part has a haze of 8% and glossiness of 75. Performance of the small pitch LED display module is characterized, and visible light reflectivity is 1%.

### Embodiment 4

A manufacturing process for a small pitch LED display module in the embodiment is the same as embodiment 1, and differences are as follows.

The surface roughness of the AG frosted plate is 0.2 µ m, the lamination pressure is 0.02MPa, the thickness of the second colloid part in the formed protective colloid is 0.5mm, the surface of the side, far away from the circuit board, of the second colloid part is a rough surface with roughness of 1 µ m, and the second colloid part has a haze of 4% and glossiness of 85. Performance of the small pitch LED display module is characterized, and visible light reflectivity is 0.8%.

### Contrast example 1

A small pitch LED display module is manufactured in the contrast example, and a specific process is as follows.

An LED lamp panel is selected, with a model number of TVH2.5, and is arranged on a mounting substrate. Dot distance of its LEDs is 2.5mm, and a dimension of the LED lamp panel is 200X 150mm.

The LED lamp panel is packaged by virtue of glass, a thickness of the glass being 2mm, to form the small pitch LED display module.

Performance of the small pitch LED display module is characterized, a reflectivity detector is used to detect reflectivity of a surface of the module, and visible light reflectivity is 8%. A moire display image obtained by converting an original image of the small pitch LED display module into a grayscale image and performing Fourier transform is shown in Fig. 8.

From the above data, it can be seen that the visible light reflectivity of the small pitch LED display module manufactured in the embodiment of the present disclosure is obviously reduced, which may effectively weaken the shortcoming of picture whitening caused by strong backlight and make an image displayed more clearly. In addition, contrast between FIG. 7 and FIG. 8 shows that the moire of the small pitch LED display module manufactured in the present invention is obviously weakened. Thus it can be seen that the moire is obviously weakened. In a word, the small pitch LED display module manufactured in the present disclosure has higher optical performance. In addition, an LED protection process for the small pitch LED display module of the present disclosure is simple, high in reliability and lower in cost.

From the above description, it can be seen that the embodiments of the present disclosure have the following technical effects.

According to the small pitch LED display module provided by the present invention, the protective colloid is arranged in the gaps between and above the LEDs, and the protective colloid comprises the first colloid part and the second colloid part, so that the first colloid part positioned in the gaps and the second colloid part positioned above the LEDs may realize a good protection function on each LED, and the problems of collision of the LEDs and LED damage caused by excessive humidity may be effectively prevented. Meanwhile, the second colloid part is also positioned above each LED and the first colloid part, so that a surface of the LED lamp panel is easier to clean. In addition, the thickness of the second colloid part is smaller than 1.0mm, the surface of the side, far away from the circuit board, of the second colloid part is a rough surface, and the smaller thickness and the rough surface are favorable for improving an antireflection effect of the protective colloid, thereby reducing moire problems caused by the protective colloid, endowing the small pitch LED display module of the present disclosure with higher anti-glare performance at the same time of protecting the LEDs better and keeping higher optical performance. Moreover, a processing manner for the protective colloid is simple, convenient and reliable for processing and suitable for industrial application.

Specifically, the manufacturing method for the small pitch LED display module provided by the present invention has the following advantages:
the process is simple, easy to operate, less in investment and low in cost, and no complex molds and tools are required;
a verification time is short (if a mold is adopted, tests are required to be repeatedly made and a period is long);
the reliability is high, and particularly due to adoption of the normal temperature curable glue which may be cured without heating, the protective colloid is slightly deformed, and damage to the LEDs may be avoided;
a membrane lamination condition may be secondarily regulated before curing, so that bubbles are completely solved; and
the frosted plate for lamination may be reused, so that the surface of the module is high in consistency, and the optical performance of the LED display module is ensured.

The above are only the preferred embodiments of the present invention and not intended to limit the present invention. For those skilled in the art, the present invention may have various modifications and variations. The scope of protection of the present invention is defined by the appended claims.

## Claims

1. A small pitch LED display module, comprising:
a mounting substrate (10);
an LED lamp panel (20), the LED lamp panel (20) comprising a circuit board (21) and multiple LEDs (22) arranged on the circuit board (21) at intervals, the circuit board (21) being arranged on a surface of one side of the mounting substrate (10) and the LEDs (22) being arranged on a surface of the side of the circuit board (21), which is facing away from the mounting substrate (10); and
a protective colloid (30), the protective colloid (30) comprising a first colloid part (31) and a second colloid part (32), the protective colloid (30) being integrally formed by simultaneously curing the first colloid part (31) and the second colloid part (32); the first colloid part (31) being arranged in gaps between the LEDs (22), the second colloid part (32) being positioned on upper surfaces of the first colloid part (31) and the LEDs (22), a thickness of the second colloid part (32) being smaller than 1.0 mm and a surface of the side of the second colloid part (32), which is facing away from the circuit board (21), being a rough surface integrally formed with the protective colloid (30) and having a rughness of 0.2-2.0 µm.

2. The small pitch LED display module as claimed in claim 1, wherein the protective colloid (30) is a hardened colloid formed by curing normal temperature curable glue; and preferably, the normal temperature curable glue is selected from a resin adhesive, the resin adhesive is preferably an epoxy resin adhesive and/or modified silica gel, and preferably, a coloring agent and/or a dispersant are/is added into the resin adhesive.

3. The small pitch LED display module as claimed in claim 1 or 2, wherein the second colloid part (32) has a haze of 4-8 % and glossiness of 75-85.

4. A manufacturing method for the small pitch LED display module as claimed in any one of claims 1-3, comprising the following steps:
providing a mounting substrate (10);
arranging an LED lamp panel (20) on a surface of one side of the mounting substrate (10), the LED lamp panel (20) comprising a circuit board (21) and multiple LEDs (22) arranged on the circuit board (21) at intervals, the circuit board (21) being arranged on a surface of one side of the mounting substrate (10) and the LEDs (22) being arranged on a surface of the side of the circuit board (21), which is facing away from the mounting substrate (10);
performing glue filling on the side of the LED lamp panel (20), which is facing away from the mounting substrate (10), by adopting glue;
laminating the side bearing the glue by virtue of a frosted plate to enable the glue to enter gaps between the LEDs (22) and extrude redundant glue, and performing curing of the glue to integrally form a protective colloid (30) to further form a prefabricated module, wherein a surface, contacting with the glue, of the frosted plate is a rough surface having a roughness of 0.2-2.0 µm; the protective colloid (30) comprising a first colloid part (31) and a second colloid part (32), the first colloid part (31) being arranged in gaps between the LEDs (22), the second colloid part (32) being positioned on upper surfaces of the first colloid part (31) and the LEDs (22), a thickness of the second colloid part (32) being smaller than 1.0 mm; and
removing the frosted plate in the prefabricated module to form the small pitch LED display module.

5. The manufacturing method as claimed in claim 4, wherein a glue filling process is implemented in a vacuum environment.

6. The manufacturing method as claimed in claim 5, wherein the glue filling process comprises the following step: reciprocally moving a glue gun above the side, far away from the mounting substrate (10), of the LED lamp panel (20), and discharging the glue at the same time of reciprocal movement.

7. The manufacturing method as claimed in any one of claims 4-6, wherein the glue is normal temperature curable glue, the normal temperature curable glue is preferably selected from a resin adhesive, the resin adhesive is preferably an epoxy resin adhesive and/or modified silica gel, and a coloring agent and/or a dispersant are/is preferably added into the resin adhesive.

8. The manufacturing method as claimed in any one of claims 4-6, wherein the frosted plate is a frosted glass or an AG frosted membrane.

9. The manufacturing method as claimed in claim 8, wherein a thickness of the frosted plate is 0.1-1.0 mm.

10. The manufacturing method as claimed in claim 8, wherein pressure in a lamination process is 0.005-0.040 MPa, and a curing time in a curing process is 0.5-6.0 h.

## Patentansprüche

1. LED-Anzeigemodul mit kleiner Teilung, umfassend:
ein Montagesubstrat (10);
ein LED-Lampenpaneel (20), wobei das LED-Lampenpaneel (20) eine Leiterplatte (21) und mehrere LED (22) umfasst, die auf der Leiterplatte (21) in Intervallen angeordnet sind, wobei die Leiterplatte (21) auf einer Oberfläche einer Seite des Montagesubstrats (10) angeordnet ist und die LED (22) auf einer Oberfläche der Seite der Leiterplatte (21) angeordnet sind, die von dem Montagesubstrat (10) abgewandt ist; und
ein Schutzkolloid (30), wobei das Schutzkolloid (30) einen ersten Kolloidteil (31) und einen zweiten Kolloidteil (32) umfasst, wobei das Schutzkolloid (30) einstückig durch gleichzeitiges Härten des ersten Kolloidteils (31) und des zweiten Kolloidteils (32) gebildet wird;
wobei der erste Kolloidteil (31) in Spalten zwischen den LED (22) angeordnet ist, der zweite Kolloidteil (32) auf oberen Oberflächen des ersten Kolloidteils (31) und der LED (22) positioniert ist, eine Dicke des zweiten Kolloidteils (32) kleiner als 1,0 mm ist und eine Oberfläche der Seite des zweiten Kolloidteils (32), die von der Leiterplatte (21) abgewandt ist, eine raue Oberfläche ist, die einstückig mit dem Schutzkolloid (30) gebildet ist und eine Rauigkeit von 0,2-2,0 µm aufweist.

2. LED-Anzeigemodul mit kleiner Teilung nach Anspruch 1, wobei das Schutzkolloid (30) ein gehärtetes Kolloid ist, das durch Härten eines bei normaler Temperatur härtbaren Klebstoffs gebildet wird; und wobei der bei normaler Temperatur härtbare Klebstoff vorzugsweise aus einem Harzkleber ausgewählt ist, der Harzkleber vorzugsweise ein Epoxidharzkleber und/oder modifiziertes Silicagel ist, und wobei dem Harzkleber vorzugsweise ein Farbmittel und/oder ein Dispersionsmittel zugesetzt wird/werden.

3. LED-Anzeigemodul mit kleiner Teilung nach Anspruch 1 oder 2, wobei der zweite Kolloidteil (32) eine Trübung von 4-8 % und einen Glanz von 75-85 aufweist.

4. Herstellungsverfahren für das LED-Anzeigemodul mit kleiner Teilung nach einem der Ansprüche 1-3, umfassend die folgenden Schritte:
Bereitstellen eines Montagesubstrats (10);
Anordnen eines LED-Lampenpaneels (20) auf einer Oberfläche einer Seite des Montagesubstrats (10), wobei das LED-Lampenpaneel (20) eine Leiterplatte (21) und mehrere LED (22) umfasst, die auf der Leiterplatte (21) in Intervallen angeordnet sind, wobei die Leiterplatte (21) auf einer Oberfläche einer Seite des Montagesubstrats (10) angeordnet ist und die LED (22) auf einer Oberfläche der Seite der Leiterplatte (21) angeordnet sind, die von dem Montagesubstrat (10) abgewandt ist;
Durchführen des Klebstofffüllens auf der Seite des LED-Lampenpaneels (20), die vom Montagesubstrat (10) abgewandt ist, indem Klebstoff angewendet wird;
Laminieren der Seite, die den Klebstoff trägt, aufgrund einer mattierten Platte, um es dem Klebstoff zu ermöglichen, in Spalte zwischen den LED (22) einzudringen und überschüssigen Klebstoff zu verdrängen, und Durchführen des Aushärtens des Klebstoffs, um einstückig ein Schutzkolloid (30) zu bilden, um weiter ein vorgefertigtes Modul zu bilden, wobei eine Oberfläche der mattierten Platte, die mit dem Klebstoff in Kontakt steht, eine raue Oberfläche ist, die eine Rauigkeit von 0,2-2,0 µm aufweist;
wobei das Schutzkolloid (30) einen ersten Kolloidteil (31) und einen zweiten Kolloidteil (32) umfasst, wobei der erste Kolloidteil (31) in Spalten zwischen den LED (22) angeordnet ist, der zweite Kolloidteil (32) auf oberen Oberflächen des ersten Kolloidteils (31) und der LED (22) positioniert ist, wobei eine Dicke des zweiten Kolloidteils (32) kleiner als 1,0 mm ist; und
Entfernen der mattierten Platte im vorgefertigten Modul, um das LED-Anzeigemodul mit kleiner Teilung zu bilden.

5. Herstellungsverfahren nach Anspruch 4, wobei ein Klebstofffüllverfahren in einer Vakuumumgebung ausgeführt wird.

6. Herstellungsverfahren nach Anspruch 5, wobei das Klebstofffüllverfahren den folgenden Schritt umfasst: wechselseitiges Bewegen einer Klebstoffpistole über die vom Montagesubstrat (10) weit entfernte Seite des LED-Lampenpaneels (20) und Entladen des Klebstoffs zur gleichen Zeit der wechselseitigen Bewegung.

7. Herstellungsverfahren nach einem der Ansprüche 4-6, wobei der Klebstoff ein bei normaler Temperatur härtbarer Klebstoff ist, der bei normaler Temperatur härtbare Klebstoff vorzugsweise aus einem Harzkleber ausgewählt ist, der Harzkleber vorzugsweise ein Epoxidharzkleber und/oder modifiziertes Silicagel ist, und dem Harzkleber vorzugsweise ein Färbemittel und/oder ein Dispersionsmittel zugesetzt wird/werden.

8. Herstellungsverfahren nach einem der Ansprüche 4-6, wobei die mattierte Platte ein mattiertes Glas oder eine AG-mattierte Membran ist.

9. Herstellungsverfahren nach Anspruch 8, wobei eine Dicke der mattierten Platte 0,1-1,0 mm beträgt.

10. Herstellungsverfahren nach Anspruch 8, wobei der Druck in einem Laminierungsverfahren 0,005-0,040 MPa beträgt und eine Aushärtungszeit in einem Aushärtungsverfahren 0,5-6,0 Stunden beträgt.

## Revendications

1. Module d'affichage à DEL à petit pas, comprenant :
un substrat de montage (10) ;
un panneau de lampe à DEL (20), le panneau de lampe à DEL (20) comprenant une carte de circuit imprimé (21) et plusieurs DEL (22) disposées à intervalles sur la carte de circuit imprimé (21), la carte de circuit imprimé (21) étant disposée sur une surface d'un côté du substrat de montage (10) et les DEL (22) étant disposées sur une surface du côté de la carte de circuit imprimé (21), qui s'éloigne du substrat de montage (10) ; et
un colloïde protecteur (30), le colloïde protecteur (30) comprenant une première partie colloïdale (31) et une seconde partie colloïdale (32), le colloïde protecteur (30) étant formé d'un seul tenant par durcissement simultané de la première partie colloïdale (31) et de la seconde partie colloïdale (32) ;
la première partie colloïdale (31) étant disposée dans des espaces entre les DEL (22), la seconde partie colloïdale (32) étant positionnée sur les surfaces supérieures de la première partie colloïdale (31) et des DEL (22), une épaisseur de la seconde partie colloïdale (32) étant inférieure à 1,0 mm et une surface du côté de la seconde partie colloïdale (32), qui s'éloigne de la carte de circuit imprimé (21), étant une surface rugueuse formée d'un seul tenant avec le colloïde protecteur (30) et ayant une rugosité de 0,2 à 2,0 µm.

2. Module d'affichage à DEL à petit pas selon la revendication 1, dans lequel le colloïde protecteur (30) est un colloïde durci formé par durcissement d'une colle durcissable à température normale ; et de préférence, la colle durcissable à température normale est choisie parmi un adhésif à base de résine, l'adhésif à base de résine est de préférence un adhésif à base de résine époxy et/ou un gel de silice modifié et, de préférence, un agent colorant et/ou un dispersant sont/est ajouté(s) à l'adhésif à base de résine.

3. Module d'affichage à DEL à petit pas selon la revendication 1 ou 2, dans lequel la seconde partie colloïdale (32) a un trouble de 4 à 8 % et une brillance de 75 à 85.

4. Procédé de fabrication pour le module d'affichage à DEL à petit pas selon l'une quelconque des revendications 1 à 3, comprenant les étapes suivantes :
fourniture d'un substrat de montage (10) ;
agencement d'un panneau de lampe à DEL (20) sur une surface d'un côté du substrat de montage (10), le panneau de lampe à DEL (20) comprenant une carte de circuit imprimé (21) et de multiples DEL (22) disposées à intervalles sur la carte de circuit imprimé (21), la carte de circuit imprimé (21) étant disposée sur une surface d'un côté du substrat de montage (10) et les DEL (22) étant disposées sur une surface du côté de la carte de circuit imprimé (21), qui s'éloigne du substrat de montage (10) ;
réalisation d'un remplissage de colle sur le côté du panneau de lampe à DEL (20), qui s'éloigne du substrat de montage (10), par adaptation de la colle ;
stratification du côté portant la colle grâce à une plaque dépolie pour permettre à la colle de pénétrer dans les espaces entre les DEL (22) et d'extruder la colle superflue et durcissement de la colle pour former d'un seul tenant un colloïde protecteur (30) pour former en outre un module préfabriqué, une surface, en contact avec la colle, de la plaque dépolie étant une surface rugueuse ayant une rugosité de 0,2 à 2,0 µm ;
le colloïde protecteur (30) comprenant une première partie colloïdale (31) et une seconde partie colloïdale (32), la première partie colloïdale (31) étant disposée dans des espaces entre les DEL (22), la seconde partie colloïdale (32) étant positionnée sur les surfaces supérieures de la première partie colloïdale (31) et des DEL (22), une épaisseur de la seconde partie colloïdale (32) étant inférieure à 1,0 mm ; et
retrait de la plaque dépolie dans le module préfabriqué pour former le module d'affichage à DEL à petit pas.

5. Procédé de fabrication selon la revendication 4, dans lequel un processus de remplissage de colle est mis en œuvre dans un environnement sous vide.

6. Procédé de fabrication selon la revendication 5, dans lequel le processus de remplissage de colle comprend l'étape suivante : mouvement alternatif d'un pistolet à colle au-dessus du côté, loin du substrat de montage (10), du panneau de lampe à DEL (20) et déversement de la colle en même temps que le déplacement alternatif.

7. Procédé de fabrication selon l'une quelconque des revendications 4 à 6, dans lequel la colle est une colle durcissable à température normale, la colle durcissable à température normale est de préférence choisie parmi un adhésif à base de résine, l'adhésif à base de résine est de préférence un adhésif à base de résine époxy et/ou un gel de silice modifié et un agent colorant et/ou un dispersant sont/est de préférence ajouté(s) à l'adhésif à base de résine.

8. Procédé de fabrication selon l'une quelconque des revendications 4 à 6, dans lequel la plaque dépolie est un verre dépoli ou une membrane dépolie AG.

9. Procédé de fabrication selon la revendication 8, dans lequel une épaisseur de la plaque dépolie est de 0,1 à 1,0 mm.

10. Procédé de fabrication selon la revendication 8, dans lequel la pression dans un processus de stratification est de 0,005 à 0,040 MPa et un temps de durcissement dans un processus de durcissement est de 0,5 à 6,0 h.
